# EUROPEAN PATENT APPLICATION

(11) **EP 4 779 748 A1**
(43) Date of publication of application: **22.07.2026**
(21) Application number: 24865509.4
(22) Date of filing: 12.09.2024
(51) Int. Cl.: H01M 10/42, G01R 31/382, G01R 31/385, G01R 31/392, H01M 10/48

(54) **BATTERY CAPACITY ESTIMATION DEVICE AND BATTERY CAPACITY ESTIMATION PROGRAM**

(30) Priority: 15.09.2023 JP 2023150429
(71) Applicant: KRI, Inc., Kyoto-shi, Kyoto 600-8813 (JP); Osaka Gas Co., Ltd., Osaka-shi, Osaka 541-0046 (JP)
(72) Inventor: MIZOGUCHI Yasunori, Kyoto-shi, Kyoto 600-8813 (JP); HAYANO Akihito, Kyoto-shi, Kyoto 600-8813 (JP); KINOSHITA Hajime, Kyoto-shi, Kyoto 600-8813 (JP)
(74) Representative: LBP Lemcke, Brommer & Partner Patentanwälte mbB
(86) International application number: PCT/JP2024/032667
(87) International publication number: WO 2025/058009

(57) **Abstract**

Provided is a battery capacity estimation device and a battery capacity estimation program that can estimate a battery capacity taking the influence of a crack into account. A battery capacity estimation device for estimating a battery capacity of a secondary battery that includes a positive electrode including a positive electrode active material, a negative electrode including a negative electrode active material, and an electrolyte, the battery capacity estimation device including: a deterioration state quantity derivation unit (4) configured to derive at least one of a deterioration state quantity of the positive electrode active material due to a crack generated in the positive electrode active material as a result of volume change of the positive electrode active material occurring with charging and discharging of the secondary battery, and a deterioration state quantity of a solid electrolyte interface (SEI) film due to a crack generated in the SEI film as a result of volume change of the negative electrode active material occurring with charging and discharging of the secondary battery, the SEI film being formed on a surface of the negative electrode active material; and a battery capacity estimation unit (5) configured to estimate a battery capacity of the secondary battery after deterioration, based on the deterioration state quantity derived by the deterioration state quantity derivation unit (4).

## Description

### Technical Field

The present invention relates to a battery capacity estimation device and a battery capacity estimation program.

### Background Art

Depending on the purpose of use and the like, secondary batteries may be used under different charge-discharge conditions such as charge/discharge rates, upper and lower limit voltages, charging methods (constant current charging, constant current-constant voltage charging, constant power-constant voltage charging, multistage charging, etc.), and standing-still times. In general, deteriorations due to a plurality of different mechanisms progress in the batteries, and different charge-discharge conditions result in a complex change in each of the rates of progression of these deteriorations.

For example, Patent Document 1 (JP 2023-064746A) points out the problem that the occurrence of a rapid volume change of primary particles of a lithium composite oxide included in a positive electrode active material during charging and discharging, or the accumulation of stress due to repeated charging and discharging causes generation of cracks in secondary particles, or collapse of the crystal structure or a change (phase transition) in the crystal structure. Also, Patent Document 1 discloses a secondary battery in which positive electrode active materials having a plurality of particle sizes are mixed to suppress generation particle cracks.

Patent Document 2 (WO 2021/020290) points out the problem that a negative electrode active material in which silicon oxide is used is susceptible to cracking and isolation of particles due to repeated expansion and contraction with charging and discharging, and therefore a non-aqueous electrolyte power storage element in which silicon oxide is used has a low capacity retention rate in charge-discharge cycles. Also, Patent Document 2 discloses a battery design for suppressing the particle crack in the negative electrode active material by limiting the usable potential range of the negative electrode during charging and discharging.

### Prior Art Documents

### Patent Documents

Patent Documents 1: JP 2023-064746A
Patent Documents 2: WO 2021/020290

### Disclosure of the Invention

### Problem to be Solved by the Invention

Active material designs and battery designs for suppressing deterioration due to a crack have been developed as described in Patent Documents 1 and 2. However, these designs have been unable to completely prevent a crack for extended periods of use of secondary batteries.

In particular, the particle crack due to expansion and contraction of active materials, or a reduction in discharge capacity due to a crack in a solid electrolyte interface (SEI) film of the negative electrode is significantly dependent on the state of charge (SOC) during charging and discharging, and a noticeable reduction in capacity may occur when charging and discharging is performed in a specific SOC region.

Therefore, in order to operate a power storage system and a secondary battery system of an electric automobile and the like taking into account a reduction in capacity of the battery that may occur during an extended period of use, it is necessary to accurately predict a reduction in battery capacity due to a crack as described above. However, with the conventional simple prediction models based on the number of charge-discharge cycles, the total discharge quantity of electricity, and the like, it has been difficult to accurately predict such a strongly SOC-dependent deterioration. Accordingly, Patent Documents 1 and 2 describe the influence of the crack, but do not provide any battery capacity estimation method based on such influence.

The present invention has been made in view of the above-described problems, and it is an object thereof to provide a battery capacity estimation device and a battery capacity estimation program that can estimate a battery capacity taking the influence of a crack into account.

### Means for Solving Problem

A characteristic feature of a battery capacity estimation device according to the present invention for achieving the above-described object lies in a battery capacity estimation device for estimating a battery capacity of a secondary battery that includes a positive electrode including a positive electrode active material, a negative electrode including a negative electrode active material, and an electrolyte, the battery capacity estimation device including:
a deterioration state quantity derivation unit configured to derive at least one of a deterioration state quantity of the positive electrode active material due to a crack generated in the positive electrode active material as a result of volume change of the positive electrode active material occurring with charging and discharging of the secondary battery, and a deterioration state quantity of a solid electrolyte interface (SEI) film due to a crack generated in the SEI film as a result of volume change of the negative electrode active material occurring with charging and discharging of the secondary battery, the SEI film being formed on a surface of the negative electrode active material; and
a battery capacity estimation unit configured to estimate a battery capacity of the secondary battery after deterioration, based on the deterioration state quantity derived by the deterioration state quantity derivation unit.

On the positive electrode side, a crack is generated in the positive electrode active material as a result of volume change of the positive electrode active material occurring with charging and discharging of the secondary battery. The crack cuts off conductive paths in the positive electrode active material, thus reducing the amount of the positive electrode active material connected to the surroundings via the conductive paths. This is considered to result in a reduction in battery capacity of the secondary battery. On the negative electrode side, a crack is generated in the SEI film formed on the surface of the negative electrode active material as a result of volume change occurring in the negative electrode active material with charging and discharging of the secondary battery, and a decomposition reaction of the electrolyte occurs in a portion of the surface of the negative electrode active material that is exposed by the crack. Consequently, a new SEI film is formed on the crack portion. Therefore, it is considered that the formation of a new SEI film (i.e., the occurrence of lithium loss) due to crack extension leads to a reduction in battery capacity of the secondary battery. As such, according to this characteristic feature, it is possible to derive at least one of a deterioration state quantity indicating deterioration of the positive electrode active material due to the occurrence of volume change of the positive electrode active material, and a deterioration state quantity indicating deterioration of the SEI film due to the occurrence of volume change of the negative electrode active material, and estimate a battery capacity of the secondary battery after deterioration based on the deterioration state quantity.

Therefore, it is possible to provide a battery capacity estimation device that can estimate a battery capacity taking the influence of a crack into account.

Another characteristic feature of the battery capacity estimation device according to the present invention lines in that the battery capacity estimation device further includes:
a positive electrode SOC determination unit configured to determine a state of charge (SOC) of the positive electrode active material; and
a positive electrode stress derivation unit configured to derive, based on a product of a volume change rate of the positive electrode active material that corresponds to an SOC of the positive electrode active material at a predetermined timing, the SOC being determined by the positive electrode SOC determination unit, and the volume change rate being determined by referring to positive electrode volume characteristics indicating relations between SOCs of the positive electrode active material and volumes of the positive electrode active material, and a charge-discharge current at the predetermined timing, a stress applied to particles of the positive electrode active material at the predetermined timing,
wherein the deterioration state quantity derivation unit derives the deterioration state quantity of the positive electrode active material due to a crack generated in the positive electrode active material, the deterioration state quantity being derived based on a temporal change state of stresses applied to particles of the positive electrode active material, the stresses being derived by the positive electrode stress derivation unit at a plurality of timings.

According to the above-described characteristic feature, the positive electrode stress derivation unit can derive, based on a volume change rate of the positive electrode active material that corresponds to the SOC of the positive electrode active material at a predetermined timing that has been determined by the positive electrode SOC determination unit, a stress applied to particles of the positive electrode active material at the predetermined timing. Then, the deterioration state quantity derivation unit can derive, based on a temporal change state (e.g., a fluctuation range of stress on the particle surface, the number of cycles of stress fluctuation, or the like) of stresses applied to particles of the positive electrode active material that have been derived by the positive electrode stress derivation unit at a plurality of timings, a deterioration state quantity of the positive electrode active material due to a crack generated in the positive electrode active material.

Another characteristic feature of the battery capacity estimation device according to the present invention lies in that the positive electrode SOC determination unit determines an SOC of the positive electrode active material at the predetermined timing, based on the SOC of the secondary battery at the predetermined timing, a battery capacity of the secondary battery at a past timing before the predetermined timing, and an amount of deviation between a capacity region of the positive electrode active material and a capacity region of the negative electrode active material, and
the positive electrode stress derivation unit derives a stress applied to particles of the positive electrode active material at the predetermined timing, based on a product of the volume change rate of the positive electrode active material, the charge-discharge current at the predetermined timing, and a ratio of an initial battery capacity of the secondary battery to the battery capacity of the secondary battery at the past timing.

According to the above-described characteristic feature, the positive electrode SOC determination unit can more accurately determine the SOC of the positive electrode active material at the predetermined timing by taking into account the amount of deviation between the capacity region of the positive electrode active material and the capacity region of the negative electrode active material, or in other words, by taking into account a change in the usable range of the capacity region of the positive electrode active material. Then, the positive electrode stress derivation unit can accurately determine the stress applied to the positive electrode active material particles by taking into account the ratio of the initial battery capacity of the secondary battery to the battery capacity of the secondary battery at the past timing, or in other words, by taking into account an apparent increase in current load due to a reduction in battery capacity of the secondary battery.

Another characteristic feature of the battery capacity estimation device according to the present invention lies in that the battery capacity estimation device further includes:
a negative electrode SOC determination unit configured to determine an SOC of the negative electrode active material; and
a negative electrode stress derivation unit configured to derive, based on a volume of the negative electrode active material that corresponds to an SOC of the negative electrode active material at a predetermined timing, the SOC being determined by the negative electrode SOC determination unit, and the volume being determined by referring to negative electrode volume characteristics indicating relations between SOCs of the negative electrode active material and volumes of the negative electrode active material, a stress applied in a plane direction of the SEI film at the predetermined timing,
wherein the deterioration state quantity derivation unit derives the deterioration state quantity of the SEI film due to a crack generated in the SEI film, the deterioration state quantity being derived based on a temporal change state of stresses applied in the plane direction of the SEI film, and the stresses being derived by the negative electrode stress derivation unit at a plurality of timings.

According to the above-described characteristic feature, the negative electrode stress derivation unit can derive, based on the volume of the negative electrode active material that corresponds to the SOC of the negative electrode active material at a predetermined timing that has been determined by the negative electrode SOC determination unit, a stress applied in the plane direction of SEI film at the predetermined timing. Then, the deterioration state quantity derivation unit can derive, based on a temporal change state (e.g., a fluctuation range of stress, the number of cycles of stress fluctuation, or the like) of the stress applied in the plane direction of the SEI film, the temporal change state having been derived by the negative electrode stress derivation unit at a plurality of timings, a deterioration state quantity of the SEI film due to a crack generated in the SEI film.

Another characteristic feature the of the battery capacity estimation device according to the present invention lies in that the negative electrode SOC determination unit determines an SOC of the negative electrode active material, based on the SOC of the secondary battery at the predetermined timing, a battery capacity of the secondary battery at a past timing before the predetermined timing, and a capacity of the negative electrode active material.

According to the above-described characteristic feature, it is possible to determine the SOC of the negative electrode active material, based on the SOC of the secondary battery at the predetermined timing, the battery capacity of the secondary battery at the past timing before the predetermined timing, and the capacity of the negative electrode active material.

A characteristic feature of a battery capacity estimation program according to the present invention for achieving the above-described object lies in causing a computer to function as the units included in the above-described battery capacity estimation device.

According to the above-described characteristic feature, it is possible to achieve the same effect as the above-described effect achieved by the battery capacity estimation device of the present invention by causing a computer to function as the units included in the battery capacity estimation device.

### Brief Description of the Drawings

FIG. 1 is a diagram showing a configuration of a battery capacity estimation device according to a first embodiment.
FIG. 2 is a graph illustrating an OCV of a secondary battery, OCPs of a positive electrode active material and a negative electrode active material, and capacity regions of the positive electrode active material and the negative electrode active material.
FIG. 3 shows graphs showing transitions of currents and SOCs, respectively, when charging and discharging is performed under a condition 1.
FIG. 4 shows graphs showing transitions of currents and SOCs, respectively, when charging and discharging is performed under a condition 2.
FIG. 5 shows graphs showing transitions of currents and SOCs, respectively, when charging and discharging is performed under a condition 3.
FIG. 6 shows transitions of capacities (actual measured values) of the secondary battery when charging and discharging is performed under the conditions 1 to 3.
FIG. 7 is a graph showing transitions of capacities (actual measured values), capacities (estimated values), and deterioration state quantities when charging and discharging is performed under the condition 1 in the first embodiment.
FIG. 8 is a graph showing transitions of capacities (actual measured values), capacities (estimated values), and deterioration state quantities when charging and discharging is performed under the condition 2 in the first embodiment.
FIG. 9 is a graph showing transitions of capacities (actual measured values), capacities (estimated values), and deterioration state quantities when charging and discharging is performed under the condition 3 in the first embodiment.
FIG. 10 is a graph showing transitions of capacities (actual measured values), capacities (estimated values), and deterioration state quantities when charging and discharging is performed under the condition 1 in a second embodiment.
FIG. 11 is a graph showing transitions of capacities (actual measured values), capacities (estimated values), and deterioration state quantities when charging and discharging is performed under the condition 2 in the second embodiment.
FIG. 12 is a graph showing transitions of capacities (actual measured values), capacities (estimated values), and deterioration state quantities when charging and discharging is performed under the condition 3 in the second embodiment.
FIG. 13 is a diagram showing a configuration of a battery capacity estimation device according to a third embodiment.
FIG. 14 is a graph showing transitions of capacities (actual measured values), capacities (estimated values), and deterioration state quantities when charging and discharging is performed under the condition 1 in the third embodiment.
FIG. 15 is a graph showing transitions of capacities (actual measured values), capacities (estimated values), and deterioration state quantities when charging and discharging is performed under the condition 2 in the third embodiment.
FIG. 16 is a graph showing transitions of capacities (actual measured values), capacities (estimated values), and deterioration state quantities when charging and discharging is performed under the condition 3 in the third embodiment.
FIG. 17 is a diagram showing a configuration of a battery capacity estimation device according to a fourth embodiment.
FIG. 18 is a graph showing transitions of capacities (actual measured values), capacities (estimated values), and deterioration state quantities when charging and discharging is performed under the condition 1 in the fourth embodiment.
FIG. 19 is a graph showing transitions of capacities (actual measured values), capacities (estimated values), and deterioration state quantities when charging and discharging is performed under the condition 2 in the fourth embodiment.
FIG. 20 is a graph showing transitions of capacities (actual measured values), capacities (estimated values), and deterioration state quantities when charging and discharging is performed under the condition 3 in the fourth embodiment.

### Best Mode for Carrying out the Invention

### First Embodiment

Hereinafter, a battery capacity estimation device according to a first embodiment of the present invention will be described with reference to the drawings. The battery capacity estimation device is a device for estimating the battery capacity of a secondary battery that includes a positive electrode including a positive electrode active material, a negative electrode including a negative electrode active material, and an electrolyte. The following embodiment will be described for a case where a lithium nickelate (NCA)-based positive electrode active material is used as the positive electrode active material, and a graphite-based negative electrode active material is used as the negative electrode active material. However, the raw materials of the positive electrode active material and the negative electrode active material may be changed as appropriate.

In a secondary battery that includes a positive electrode including a positive electrode active material, a negative electrode including a negative electrode active material, and an electrolyte, the positive electrode active material and the negative electrode active material undergo repeated expansion and contraction when charging and discharging is repeatedly performed. It can be presumed that a crack generated due to such expansion and contraction results in occurrence of a deterioration, namely, a reduction in battery capacity of the secondary battery.

Therefore, the battery capacity estimation device includes: a deterioration state quantity derivation unit 4 that derives at least one of a deterioration state quantity of the positive electrode active material due to a crack generated in the positive electrode active material as a result of volume change of the positive electrode active material occurring with charging and discharging of the secondary battery, and a deterioration state quantity of a solid electrolyte interface (SEI) film due to a crack generated in the SEI film as a result of volume change of the negative electrode active material occurring with charging and discharging of the secondary battery, the SEI film being formed on a surface of the negative electrode active material; and a battery capacity estimation unit 5 that estimates a battery capacity of the secondary battery after deterioration, based on the deterioration state quantity derived by the deterioration state quantity derivation unit 4.

Note that the deterioration state quantity derivation unit 4 included in the battery capacity estimation device according to the first embodiment derives a deterioration state quantity of the positive electrode active material due to a crack generated in the positive electrode active material as a result of volume change of the positive electrode active material occurring with the charging and discharging of the secondary battery.

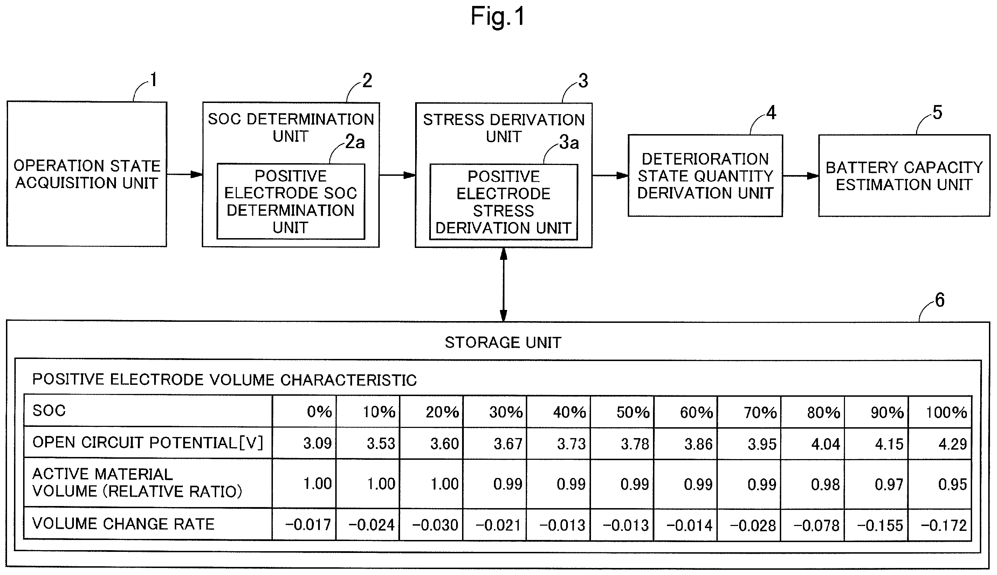

FIG. 1 is a diagram showing a configuration of the battery capacity estimation device according to the first embodiment. As illustrated, the battery capacity estimation device includes an operation state acquisition unit 1, an SOC determination unit 2, a stress derivation unit 3, the deterioration state quantity derivation unit 4, and the battery capacity estimation unit 5. In addition, the battery capacity estimation device according to the present embodiment includes a storage unit 6 that stores information to be handled. Specifically, the battery capacity estimation device according to the first embodiment derives a deterioration state of the positive electrode active material due to a crack generated in the positive electrode active material as a result of volume change of the positive electrode active material occurring with charging and discharging of the secondary battery, and estimates, based on the deterioration state, a battery capacity of the secondary battery after deterioration. Therefore, the SOC determination unit 2 includes a positive electrode SOC determination unit 2a, and the stress derivation unit 3 includes a positive electrode stress derivation unit 3a.

The battery capacity estimation device is realized with one or more computer devices including having an information input/output function, an information communication function, an information processing function, an information storage function, and the like. In the present embodiment, the battery capacity estimation device is realized by installing a battery capacity estimation program for causing the above-described one or more computer devices to function as the units of the battery capacity estimation device in a storage medium of the one or more computer devices, and executing the program. That is, the battery capacity estimation program is stored in a computer-readable storage medium (e.g., the storage unit 6 or another storage device, or a storage medium such as a CD, a DVD, or a Blu-ray (registered trademark)). A program product including the battery capacity estimation program realizes the functions of the units included in a battery capacity estimation device, which will be described later, when the battery capacity estimation program is executed by the information processing function of the computer device(s).

For example, the operation state acquisition unit 1 can be realized using the information input/output function of the computer device. The SOC determination unit 2, the stress derivation unit 3, the deterioration state quantity derivation unit 4, and the battery capacity estimation unit 5 can be realized using the information processing function of the computer device. The storage unit 6 can be realized using the information storage function of the computer device.

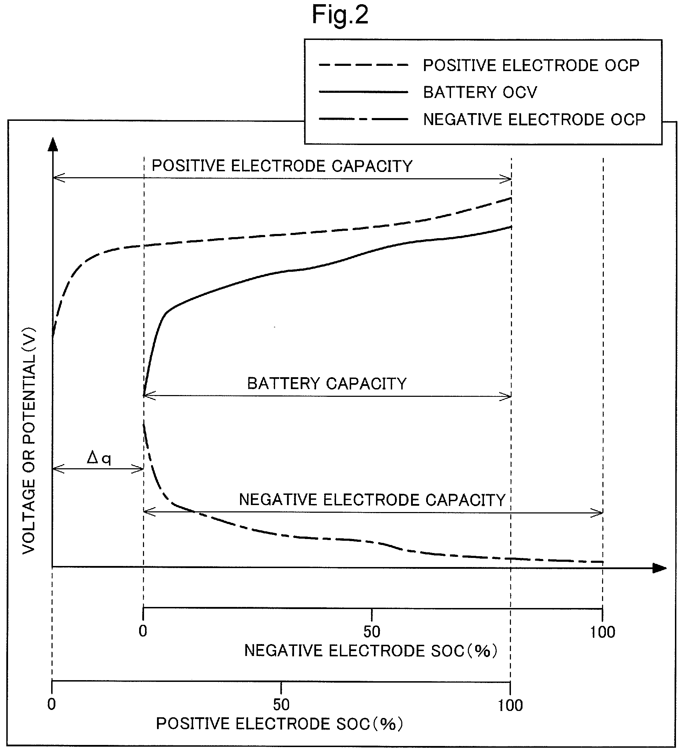

FIG. 2 is a graph illustrating an open circuit voltage (OCV) of the secondary battery, open circuit potentials (OCPs) of the positive electrode active material and the negative electrode active material, and capacity regions of the positive electrode active material and the negative electrode active material. The illustrated example depicts a case where there is an amount of deviation of Δq between the capacity region of the positive electrode active material and the capacity region of the negative electrode active material. However, Δq shown in FIG. 2 is described for purpose of illustration, and the magnitude thereof is not limited to the illustrated magnitude. Although FIG. 2 shows a relation in which the negative electrode capacity > the battery capacity, the magnitude of the negative electrode capacity is not limited to the illustrated magnitude.

The operation state acquisition unit 1 acquires information regarding an SOC of the secondary battery (hereinafter may be referred to as "battery SOC"), and information regarding a charge-discharge current of the secondary battery. Specifically, the operation state acquisition unit 1 acquires information regarding an SOC of the secondary battery and information regarding a charge-discharge current at a predetermined timing such as every one minute. For example, an OCV of the secondary battery is measured, and the SOC of the secondary battery can be derived based on a relation between a transition between the lower limit (SOC =0%) and the upper limit (SOC = 100%) of the battery capacity shown in FIG. 2, and the measured OCV Then, these pieces of information are stored in the storage unit 6 together with time information.

The positive electrode SOC determination unit 2a included in the SOC determination unit 2 determines the SOC of the positive electrode active material (hereinafter may be referred to as "positive electrode SOC"). Specifically, the positive electrode SOC determination unit 2a determines an SOC of the positive electrode active material at a predetermined timing such as every one minute.

For example, the positive electrode SOC determination unit 2a may determine an SOC of the positive electrode active material at the predetermined timing from the relation between the battery SOC and the positive electrode SOC, and the SOC of the secondary battery at the predetermined timing. In the present embodiment, as the relation between the battery SOC and the positive electrode SOC, the relation "battery SOC = positive electrode SOC" is defined as described in Expression 1 below.
[Math. 1] ${SOC}_{t}^{cathode} = {SOC}_{t}^{cell}$
${SOC}_{t}^{cathode}$ : **positive electrode SOC at time t**
${SOC}_{t}^{cell}$ : **battery** SOC at **time t**

The positive electrode stress derivation unit 3a included in the stress derivation unit 3 derives, based on a product of a volume change rate of the positive electrode active material that corresponds to an SOC of the positive electrode active material at a predetermined timing, the SOC being determined by the positive electrode SOC determination unit 2a, the volume change rate being determined by referring to positive electrode volume characteristics indicating relations between SOCs of the positive electrode active material and volumes of the positive electrode active material, and a charge-discharge current at the predetermined timing, a stress applied to particles of the positive electrode active material (e.g., stress on the particle surface) at the predetermined timing. In the present embodiment, the stress is derived based on Expression 2 below. As stored in the storage unit 6, the positive electrode volume characteristics define relations between positive electrode SOCs, open circuit potentials, active material volumes (relative ratios), and volume change rates. Note that, for simplicity of illustration, FIG. 2 describes the SOC in increments of 10%.
[Math. 2] ${σ}_{θ , max} = coef \times V ′ \left(soc\right) \times 1$
*σ*_{*θ*, *max*} : maximum stress (= stress on particle surface) applied in tangential direction of positive electrode active material particles
*coef* : proportional constant dependent on battery design
*V' (soc):* volume change rate of positive electrode active material relative to positive electrode SOC
*I* : charge-discharge current

When charging and discharging of the secondary battery is repeatedly performed, increase or decrease of the volume of the positive electrode active material is repeated with increase or decrease of the SOC of the positive electrode active material. Accordingly, it is presumed that the stress on the particle surface of the positive electrode active material also fluctuates (increases or decreases), whereby a crack is generated in the positive electrode active material.

The deterioration state quantity derivation unit 4 derives the deterioration state quantity of the positive electrode active material due to a crack generated in the positive electrode active material, the deterioration state quantity being derived based on a temporal change state (e.g., a fluctuation range of the stress on the particle surface, and the number of cycles of stress fluctuations) of stresses applied to particles of the positive electrode active material, the stresses being derived by the positive electrode stress derivation unit 3a at a plurality of timings.

First, the deterioration state quantity derivation unit 4 applies a Rainflow counting method to a fluctuation pattern of stress generated over time while charging and discharging of the secondary battery is performed, thereby calculating a fluctuation range of the stress and the number of cycles of stress fluctuation, and derives a crack density in the positive electrode active material particles based on the fluctuation range of the stress and the number of cycles. For example, in the process of performing a simulation for estimating battery capacities when charging and discharging is performed under conditions 1 to 3, which will be described later, a fluctuation range Δσᵢ of the stress and a number Nᵢ of cycles are successively counted. In the present embodiment, the crack density is derived based on Expressions 3 and 4 below.
$\begin{matrix}\begin{matrix}Δ {a}_{t} = {\sum }_{i} \left({N}_{i}\times Δ{{σ}_{l}}^{m}\right) \left(Expression 3\right) \\ {\hat{a}}_{t} = {\hat{a}}_{t - 1} + Δ {a}_{t} \left(Expression 4\right)\end{matrix} \\ \end{matrix}$
Δ*aₜ*: increment of crack density due to stress fluctuation cycles, counted from time t-1 to t
Δ*Nᵢ*: number of cycles of ith stress fluctuations counted from time t-1 to t (1 or 1.5)
ΔΔ*σ*ᵢ : fluctuation range of ith stress σ counted from time t-1 to t
*m* : exponent
*âₜ*: crack density in positive electrode active material particles at time t

On the positive electrode side, a crack is generated in the positive electrode active material as a result of volume change of the positive electrode active material occurring with charging and discharging of the secondary battery, and the crack cuts off conductive paths in the positive electrode active material, thus reducing the amount of the positive electrode active material connected to the surroundings via the conductive paths. This is considered to result in a reduction in battery capacity of the secondary battery. Therefore, the deterioration state quantity derivation unit 4 derives a capacity loss (deterioration state quantity) in the positive electrode active material, based on the amount of cracks generated in the positive electrode active material particles over time. In the present embodiment, a capacity loss (deterioration state quantity) in the positive electrode active material is derived based on Expression 5 below.
[Math. 4] ${μ}_{t}^{ctack} = {Q}_{0} \left(1-{\left(1-{{a}^{˜}}_{t}\right)}^{R}\right)$
${μ}_{t}^{ctack}$ : capacity loss (deterioration state quantity) in positive electrode active material isolated from conductive paths due to crack
*β* : index that defines probability that active material is isolated due to crack

Expression 5 above is determined based on the following concept: when a crack is generated between active material particles, some of the active material particles are isolated from the conductive paths and can no longer contribute to charging and discharging, and, based on a percolation theory, the amount of the active material connected to the conductive paths is proportional to a power of the amount of conductive paths.

The battery capacity estimation unit 5 estimates a battery capacity of the secondary battery after deterioration, based on the deterioration state quantity derived by the deterioration state quantity derivation unit 4. In the present embodiment, the battery capacity is estimated based on Expression 6 below.
[Math. 5] ${Q}_{t} = {Q}_{0} - {μ}_{t}^{ctack}$
- *Qₜ* :: battery capacity at time t
- *Q*ₒ :: initial (new) battery capacity of secondary battery

In the present embodiment, transitions of battery capacities (actual measured values) in a case where charging and discharging is performed for a predetermined test period under three types of charge-discharge conditions (conditions 1 to 3) are measured. Then, the actual measured values are compared with transitions of battery capacities (estimated values) estimated by the battery capacity estimation device according to the present embodiment, to verify the validity of the transitions of battery capacities (estimated values) estimated by the battery capacity estimation device.

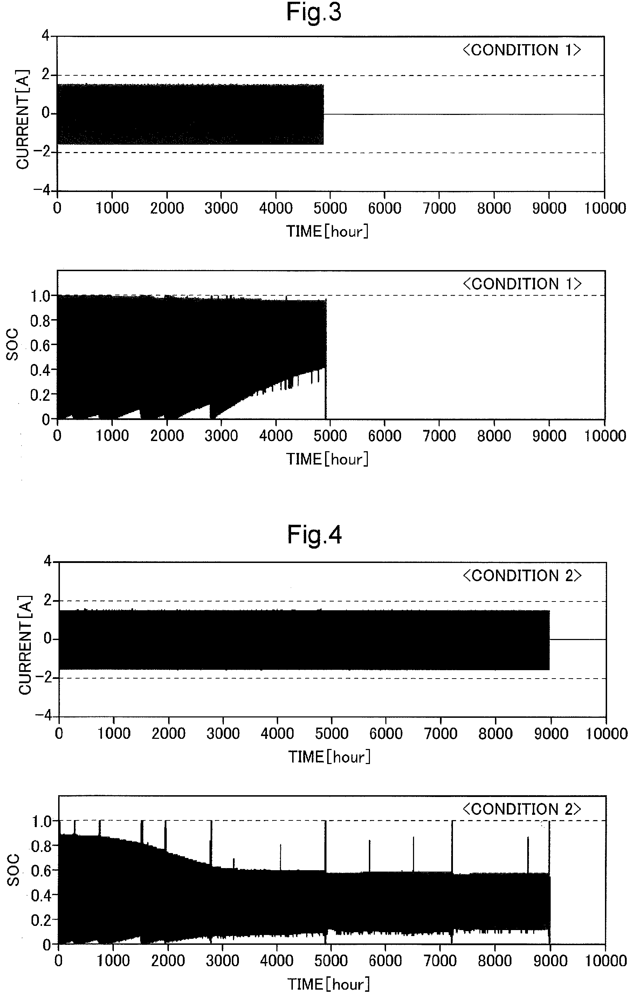

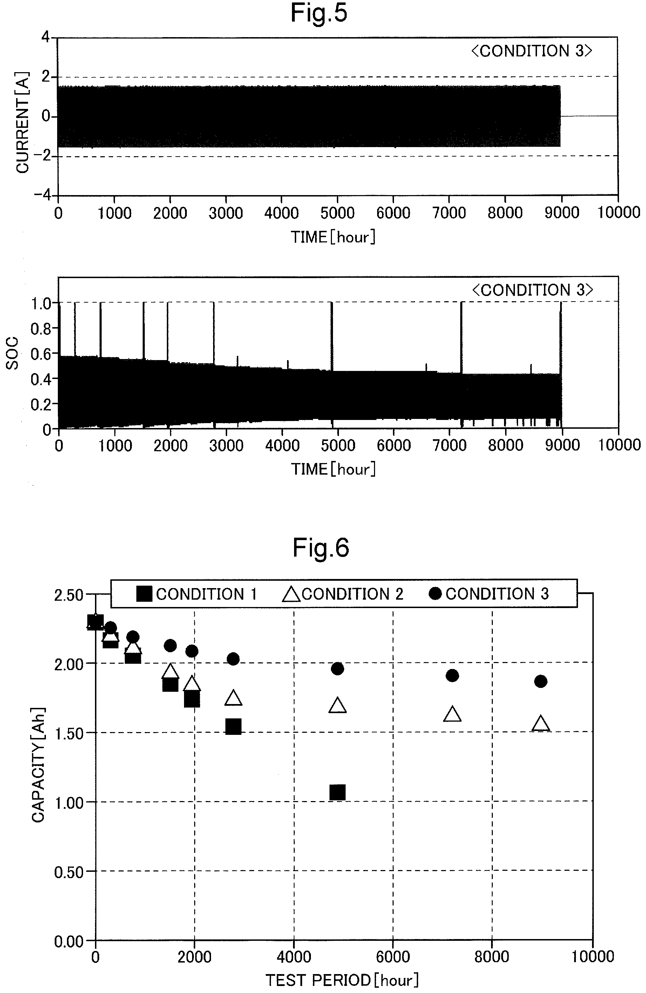

As shown in Table 1 below, under the condition 1, charging is performed with a constant current-constant voltage (CCCV) method. During charging, the current is 0.7 C, and the voltage is 4.2 V. Under the condition 2, charging is performed with a constant current (CC) method, and the charging ends at 4.2 V. The current is 0.7 C. Under the condition 3, charging is performed with a constant current (CC) method, and the charging ends at 4.0 V. The current is 1.4 C. FIGS. 3 to 5 are graphs showing transitions of currents, temperatures, and SOCs when charging and discharging is performed under the conditions. FIG. 6 shows transitions of discharge capacities (actual measured values) of the secondary battery when charging and discharging is performed under conditions 1 to 3.

**[Table 1]**

| | Condition 1 | Condition 2 | Condition 3 |
|---|---|---|---|
| Charging condition | Constant current-constant voltage method | Constant current method | Constant current method |
| | Current: 0.7 C | Current: 0.7 C | Current: 1.4 C |
| | Voltage: 4.2 V | Voltage: 4.2 V | Voltage: 4.0 V |
| | 45°C | 45°C | 45°C |
| Total discharge amount at the end of test | 1551 Ah | 3824 Ah | 4077 Ah |
| Capacity retention rate at the end of test | 46% | 68% | 81% |

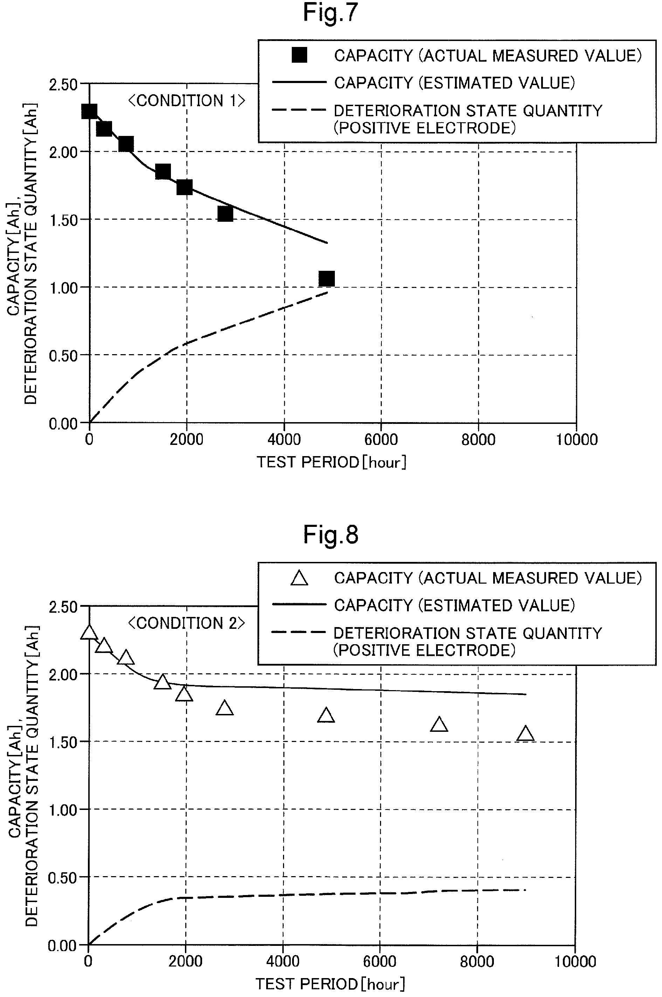

FIG. 7 is a graph showing battery capacities estimated when charging and discharging is performed under the condition 1, and a transition of actual measured values of battery capacities when charging and discharging is performed under the condition 1. FIG. 7 also shows a transition of estimated values of capacity losses (deterioration state quantities) in the positive electrode active material due to the crack. Note that, in Expressions 2, 3, and 5 described above, coef = 0.22, m = 3, and β = 0.6. As can be seen from FIG. 7, the longer the test period, the more deviated the estimated values are from the actual measured values. However, the estimated values and the actual measured values exhibit substantially the same transition up to a test period of about 2000 hours. Therefore, it can be said that the results of estimation of the battery capacity by the battery capacity estimation device according to the present embodiment are relatively accurate.

FIG. 8 is a graph showing battery capacities estimated when charging and discharging is performed under the condition 2, and a transition of actual measured values of battery capacities when charging and discharging is performed under the condition 2. FIG. 8 also shows a transition of estimated values of capacity losses (deterioration state quantities) in the positive electrode active material due to the crack. Note that, in Expressions 2, 3, and 5 described above, coef = 0.22, m = 3, and β = 0.6. As can be seen from FIG. 8, the longer the test period, the more deviated the estimated values are from the actual measured values. However, the estimated values and the actual measured values exhibit substantially the same transition up to a test period of about 2000 hours. The characteristic by which the transition of the battery capacity tends to level out after the test period exceeds 2000 hours is similar between both the estimated value and the actual measured value. Therefore, it can be said that the results of estimation of the battery capacity by the battery capacity estimation device according to the present embodiment are relatively accurate.

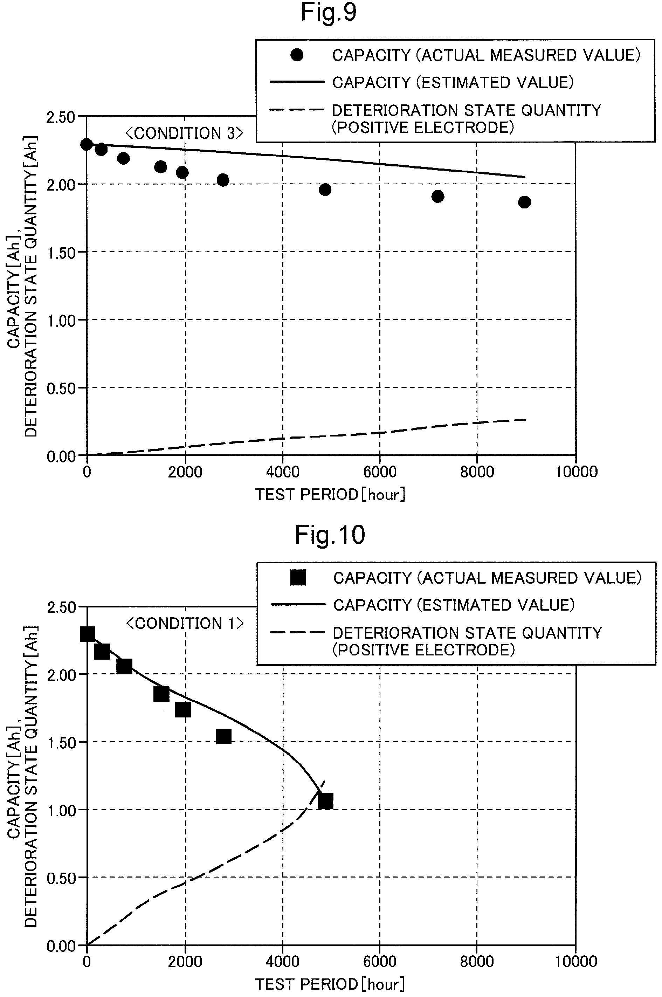

FIG. 9 is a graph showing battery capacities estimated when charging and discharging is performed under the condition 3, and a transition of actual measured values of battery capacities when charging and discharging is performed under the condition 3. FIG. 9 also shows a transition of estimated values of capacity losses (deterioration state quantities) in the positive electrode active material due to the crack. Note that, in Expressions 2, 3, and 5 described above, coef = 0.22, m = 3, and β = 0.6. As can be seen from FIG. 9, both the estimated value and the actual measured value of the battery capacity become smaller over time. Therefore, it can be said that the results of estimation of the battery capacity by the battery capacity estimation device according to the present embodiment are relatively accurate.

As described above, it can be said that the battery capacity estimation device according to the present embodiment can relatively accurately estimate the battery capacity after deterioration taking the influence of a crack into account, regardless of how charging and discharging is performed.

### Second Embodiment

A battery capacity estimation device according to a second embodiment is different from the above first embodiment with regard to the method for determining the positive electrode SOC. The battery capacity estimation device according to the second embodiment will be described below. Note that the description of configurations that are the same as those in the above-described embodiment will be omitted.

The positive electrode SOC determination unit 2a determines the SOC of the positive electrode active material at the predetermined timing from a relation between the battery SOC and the positive electrode SOC, and the SOC of the secondary battery at the predetermined timing. In the present embodiment, as the relation between the battery SOC and the positive electrode SOC, a relation as described in Expression 7 below is defined. That is, the positive electrode SOC determination unit 2a determines an SOC of the positive electrode active material at the predetermined timing, based on the SOC of the secondary battery at the predetermined timing, a battery capacity of the secondary battery at a past timing before the predetermined timing, and an amount of deviation between the capacity region of the positive electrode active material and the capacity region of the negative electrode active material.
[Math. 6] ${SOC}_{t}^{cathode} = \left({SOC}_{t}^{cell}\times {Q}_{t - 1}+Δq\right) / \left({Q}_{t - 1}+Δq\right)$
${SOC}_{t}^{cathode}$ : positive electrode SOC at time t
$SO {C}_{t}^{cell}$ : battery SOC at time t
*Q*_{*t*-1}: battery capacity at time t 1
Δ*q* : amount of deviation between capacity regions of positive and negative electrodes

The positive electrode stress derivation unit 3a derives, based on a product of a volume change rate of the positive electrode active material that corresponds to an SOC of the positive electrode active material at a predetermined timing, the SOC being determined by the positive electrode SOC determination unit 2a, and the volume change rate being determined by referring to positive electrode volume characteristics indicating relations between SOCs of the positive electrode active material and volumes of the positive electrode active material, a charge-discharge current at the predetermined timing, and a ratio of an initial battery capacity of the secondary battery to the battery capacity of the secondary battery at the past timing, a stress (e.g., stress on the particle surface, or the like) applied to particles of the positive electrode active material at the predetermined timing. In the present embodiment, the stress is derived based on Expression 8 below.
[Math. 7] ${σ}_{θ , max} - coef \times V {′}_{\left(soc\right)} \times I \times {Q}_{0} / {Q}_{t - 1}$
*σ*_{*θ*, *max*} : maximum stress (= stress on particle surface) applied in tangential direction of active material particles
*coef* : proportional constant dependent on battery design
*V'* _{(*soc*)}: volume change rate of active material relative to positive electrode SOC
*I* : charge discharge current
*Q₀*: initial battery capacity of secondary battery
*Qₜ₋₁* : battery capacity at time t

Expression 8 above is aimed at accurately determining the stress applied to the positive electrode active material particles by taking into account the ratio of the initial battery capacity of the secondary battery to the battery capacity of the secondary battery at the past timing, or in other words, by taking into account an apparent increase in current load due to a reduction in the battery capacity of the secondary battery.

As in the first embodiment described above, the deterioration state quantity derivation unit 4 derives the deterioration state quantity of the positive electrode active material due to a crack generated in the positive electrode active material, the deterioration state quantity being derived based on a temporal change state (e.g., a fluctuation range of the stress on the particle surface and the number of cycles of stress fluctuation) of stresses applied to the particles of the positive electrode active material, the stresses being derived by the positive electrode stress derivation unit 3a at a plurality of timings. For example, the deterioration state quantity derivation unit 4 derives a crack density in the positive electrode active material particles based on Expressions 3 and 4 described in the first embodiment, and derives a capacity loss (deterioration state quantity) of the positive electrode active material based on Expression 5 described in the first embodiment.

Then, as in the first embodiment described above, the battery capacity estimation unit 5 estimates a battery capacity of the secondary battery after deterioration, based on the deterioration state quantity derived by the deterioration state quantity derivation unit 4 and Expression 6 described in the first embodiment.

In the present embodiment as well, transitions of battery capacities (actual measured values) in a case where charging and discharging is performed for a predetermined test period under three types of charge-discharge conditions (conditions 1 to 3) are measured. Then, the actual measured values are compared with transitions of battery capacities (estimated values) estimated by the battery capacity estimation device according to the present embodiment, to verify the validity of the transitions of battery capacities (estimated values) estimated by the battery capacity estimation device.

Note that the conditions 1 to 3 are the same as those in the first embodiment, and the transitions (actual measured values) of the battery capacity are also the same as those in the first embodiment.

FIG. 10 is a graph showing battery capacities estimated when charging and discharging is performed under the condition 1, and a transition of actual measured values of battery capacities when charging and discharging is performed under the condition 1. FIG. 10 also shows a transition of estimated values of capacity losses (deterioration state quantities) in the positive electrode active material due to a crack. Note that, in Expressions 3, 5, 7, and 8 described above, coef = 0.185, m = 3, and β = 0.6, and Δq = 0.14. As can be seen from FIG. 10, the longer the test period, the more deviated the estimated values are from the actual measured values. However, the estimated values and the actual measured values exhibit substantially the same transition up to a test period of about 5000 hours. Therefore, it can be said that the results of estimation of the battery capacity by the battery capacity estimation device according to the present embodiment are relatively accurate.

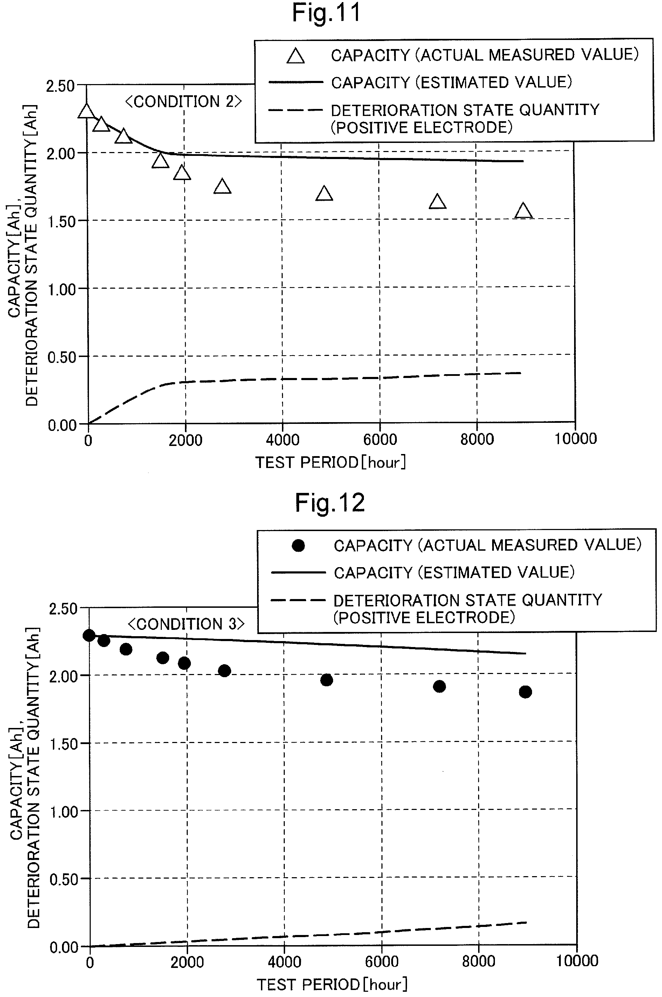

FIG. 11 is a graph showing battery capacities estimated when charging and discharging is performed under the condition 2, and a transition of actual measured values of battery capacities when charging and discharging is performed under the condition 2. FIG. 11 also shows a transition of estimated values of capacity losses (deterioration state quantities) in the positive electrode active material due to a crack. Note that, in Expressions 3, 5, 7, and 8 described above, coef = 0.185, m = 3, and β = 0.6, and Δq = 0.14. As can be seen from FIG. 11, the longer the test period, the more deviated the estimated values are from the actual measured values. However, the estimated values and the actual measured values exhibit substantially the same transition up to a test period of about 2000 hours. The characteristic by which the transition of the battery capacity tends to level out after the test period exceeds 2000 hours is similar between both the estimated value and the actual measured value. Therefore, it can be said that the results of estimation of the battery capacity by the battery capacity estimation device according to the present embodiment are relatively accurate.

FIG. 12 is a graph showing battery capacities estimated when charging and discharging is performed under the condition 3, and a transition of actual measured values of battery capacities when charging and discharging is performed under the condition 3. FIG. 12 also shows a transition of estimated values of capacity losses (deterioration state quantities) in the positive electrode active material due to a crack. Note that, in Expressions 3, 5, 7, and 8 described above, coef = 0.185, m = 3, and β = 0.6, and Δq = 0.14. As can be seen from FIG. 12, both the estimated value and the actual measured value of the battery capacity become smaller over time. Therefore, it can be said that the results of estimation of the battery capacity by the battery capacity estimation device according to the present embodiment are relatively accurate. However, the deterioration of the battery capacity is under-estimated, and the results of estimation and the actual measured values of the battery capacity do not completely match. This is presumably because a deterioration due to a crack in an SEI film of the negative electrode active material, which is not taken into account for the battery capacity estimation device of the present embodiment, is progressing although the deterioration due to a crack in the positive electrode active material particles is small.

As described above, it can be said that the battery capacity estimation device according to the present embodiment can relatively accurately estimate the battery capacity after deterioration taking the influence of a crack into account, regardless of how charging and discharging is performed.

### Third Embodiment

A battery capacity estimation device according to a third embodiment is different from the above embodiments with regard to the method for deriving the deterioration state quantity by the deterioration state quantity derivation unit 4. The battery capacity estimation device according to the third embodiment will be described below. Note that the description of configurations that are the same as those in the above-described embodiments will be omitted.

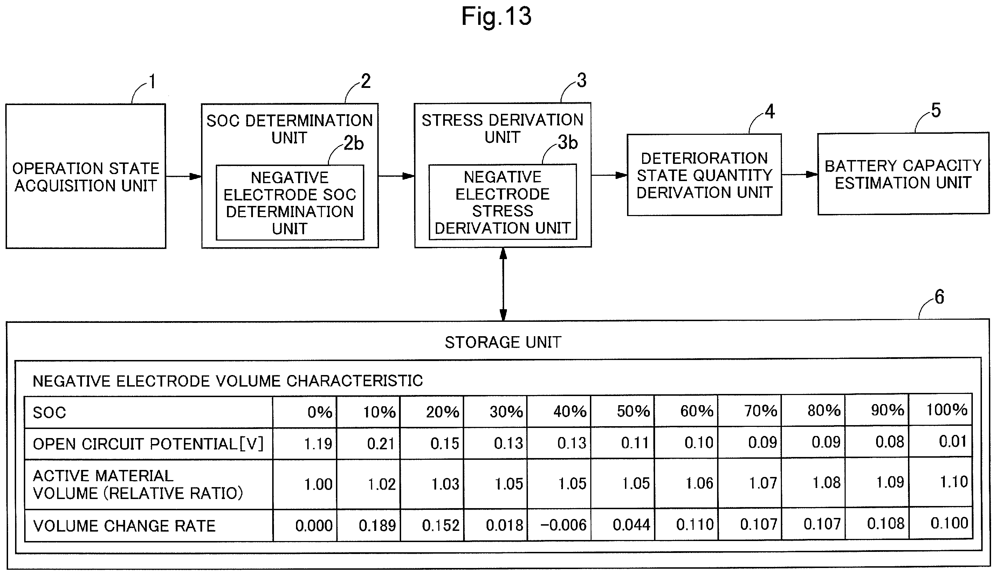

FIG. 13 is a diagram showing a configuration of the battery capacity estimation device according to the third embodiment. As illustrated, the battery capacity estimation device includes an operation state acquisition unit 1, an SOC determination unit 2, a stress derivation unit 3, the deterioration state quantity derivation unit 4, and the battery capacity estimation unit 5. Specifically, the battery capacity estimation device according to the third embodiment derives a deterioration state quantity of an SEI film formed on the surface of the negative electrode active material due to a crack generated in the SEI film as a result of volume change of the negative electrode active material occurring with charging and discharging of the secondary battery, and estimates a battery capacity of the secondary battery after deterioration, based on the deterioration state amount. Therefore, the SOC determination unit 2 includes a negative electrode SOC determination unit 2b, and the stress derivation unit 3 includes a negative electrode stress derivation unit 3b.

As will be described later, the deterioration state quantity derivation unit 4 included in the battery capacity estimation device according to the third embodiment derives a deterioration state quantity of the SEI film due to a crack generated in the SEI film formed on a surface of the negative electrode active material as a result of volume change occurring in the negative electrode active material with charging and discharging of the secondary battery.

First, the negative electrode SOC determination unit 2b included in the SOC determination unit 2 determines the SOC of the negative electrode active material (hereinafter may be referred to as "negative electrode SOC"). Specifically, the negative electrode SOC determination unit 2b determines an SOC of the negative electrode active material at a predetermined timing such as every one minute.

For example, the negative electrode SOC determination unit 2b determines an SOC of the negative electrode active material at the predetermined timing from the relation between the battery SOC and the negative electrode SOC, and the SOC of the secondary battery at the predetermined timing. In the present embodiment, as the relation between the battery SOC and the negative electrode SOC, the relation "battery SOC = negative electrode SOC" is defined as described in Expression 9 below.
[Math. 8] $SO {C}_{t}^{anode} = SO {C}_{t}^{cell}$
$SO {C}_{t}^{anode}$ : negative electrode SOC at time t
SOCₜ^{cell} : battery SOC at time t

The negative electrode stress derivation unit 3b included in the stress derivation unit 3 derives, based on a volume of the negative electrode active material that corresponds to an SOC of the negative electrode active material at a predetermined timing, the SOC being determined by the negative electrode SOC determination unit 2b, and the volume being determined by referring to negative electrode volume characteristics indicating relations between SOCs of the negative electrode active material and volumes of the negative electrode active material, a stress applied in a plane direction of the SEI film at the predetermined timing. In the present embodiment, the stress is derived based on Expression 10 below. As stored in the storage unit 6, the negative electrode volume characteristics define relations between negative electrode SOCs, open circuit potentials, active material volumes (relative ratios), and volume change rates. Note that, for simplicity of illustration, FIG. 13 describes the SOC in increments of 10%.
[Math. 9] ${σ}_{θ , max} = coef \times {V}_{\left(soc\right)}$
- *σ*_{*θ*, *max*} :: stress applied in plane direction of SEI film
- *coef* :: proportional constant dependent on battery design
- *V_{(SOC)}*:: active material volume (relative value with respect to SOC 0%)

The deterioration state quantity derivation unit 4 derives the deterioration state quantity of the SEI film due to a crack generated in the SEI film, the deterioration state quantity being derived based on a temporal change state (a fluctuation range of stresses and the number of cycles of stress fluctuation) of stresses applied in the plane direction of the SEI film, and the stresses being derived by the negative electrode stress derivation unit 3b at a plurality of timings.

First, the deterioration state quantity derivation unit 4 derives an increment of a crack density in the SEI film of the negative electrode, based on a fluctuation range of stress generated over time, and the number of cycles of stress fluctuation counted using the Rainflow counting method. In the present embodiment, the increment of the crack density is derived based on Expression 11 below.
[Math. 10] $Δ {μ}_{i} = {\sum }_{i} \left({N}_{l}\times Δ{σ}_{l}^{m}\right)$
- Δ*µₜ* :: increment of deterioration state quantity due to crack in SEI film due to stress fluctuation cycles, counted from time t-1 to t
- *N*ᵢ:: number of cycles of ith stress fluctuation counted from time t-1 to t (1 or 1.5)
- Δ*σᵢ* :: fluctuation range of ith stress σ counted from time t-1 to t
- *m* :: exponent

Next, the deterioration state quantity derivation unit 4 derives a deterioration state quantity of the SEI film due to a crack generated in the SEI film, the deterioration state quantity being derived based on a temporal change state (a fluctuation range of stress and the number of cycles of stress fluctuation) of stresses applied in plane direction of the SEI film, the stresses being derived by the negative electrode stress derivation unit 3b at a plurality of timings. In the present embodiment, the deterioration state quantity of the SEI film of the negative electrode active material is derived based on Expression 12 below.
[Math. 11] ${μ}_{i}^{SEI} = {μ}_{i - 1}^{SEI} + Δ {μ}_{i}$
${μ}_{i}^{SEI}$ : deterioration state quantity due to crack in SEI film at time t

On the negative electrode side, a crack is generated in the SEI film formed on the surface of the negative electrode active material as a result of volume change occurring in the negative electrode active material with charging and discharging of the secondary battery, and a decomposition reaction of the electrolyte occurs in a portion of the surface of the negative electrode active material that is exposed by the crack. Consequently, a new SEI film is formed on the crack portion. Expression 12 above is determined based on the concept that the formation of a new SEI film (i.e., the occurrence of lithium loss) due to crack extension leads to a reduction in battery capacity of the secondary battery.

The battery capacity estimation unit 5 estimates a battery capacity of the secondary battery after deterioration, based on the deterioration state quantity derived by the deterioration state quantity derivation unit 4. In the present embodiment, the battery capacity is estimated based on Expression 13 below.
[Math. 12] ${Q}_{t} = {Q}_{0} - {μ}_{t}^{SEI}$
- *Qₜ:*: battery capacity at time t
- *Q_{D}*:: initial (new) battery capacity of secondary battery

In the present embodiment as well, transitions of battery capacities (actual measured values) in a case where charging and discharging is performed for a predetermined test period under three types of charge-discharge conditions (conditions 1 to 3) are measured. Then, the actual measured values are compared with transitions of battery capacities (estimated values) estimated by the battery capacity estimation device according to the present embodiment, to verify the validity of the transitions of battery capacities (estimated values) estimated by the battery capacity estimation device.

Note that the conditions 1 to 3 are the same as those in the first embodiment, and the transitions (actual measured values) of the battery capacity are also the same as those in the first embodiment.

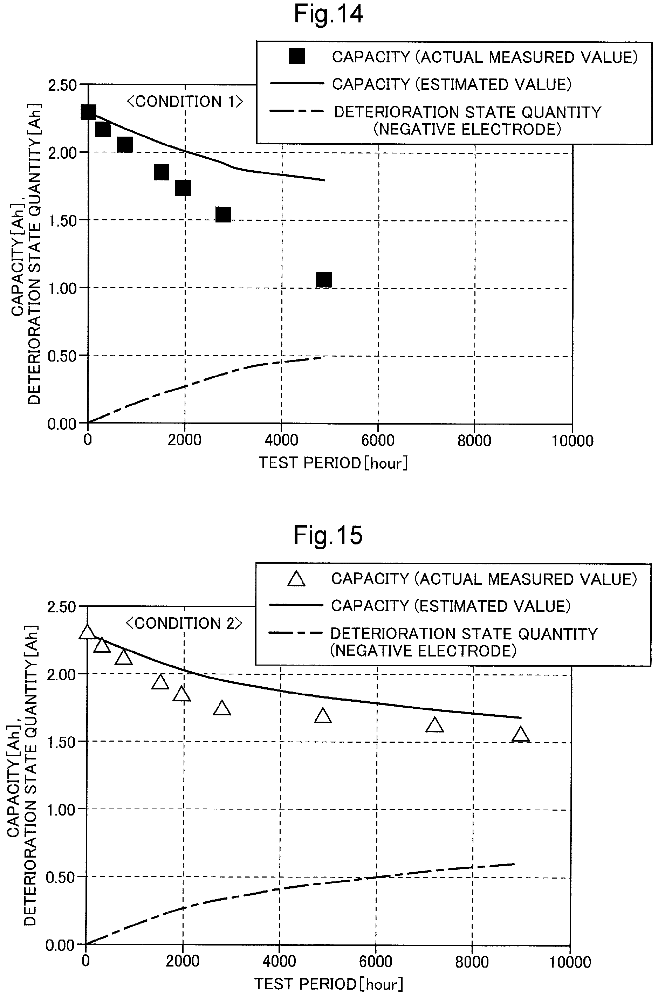

FIG. 14 is a graph showing battery capacities estimated when charging and discharging is performed under the condition 1, and a transition of actual measured values of battery capacities when charging and discharging is performed under the condition 1. FIG. 14 also shows a transition of estimated values of capacity losses (deterioration state quantities) in the negative electrode active material due to a crack in the SEI film. Note that, in Expressions 10 and 11 described above, coef = 0.17 and m = 2. As can be seen from FIG. 14, the longer the test period, the more deviated the estimated values are from the actual measured values. However, both the estimated values and the actual measured values exhibit the tendency to decrease. Therefore, it can be said that the results of estimation of the battery capacity by the battery capacity estimation device according to the present embodiment are relatively accurate.

FIG. 15 is a graph showing battery capacities estimated when charging and discharging is performed under the condition 2, and a transition of actual measured values of battery capacities when charging and discharging is performed under the condition 2. FIG. 15 also shows a transition of estimated values of capacity losses (deterioration state quantities) in the negative electrode active material due to a crack in the SEI film. Note that, in Expressions 10 and 11 described above, coef = 0.17 and m = 2. As can be seen from FIG. 15, the estimated values and the actual measured values are deviated from each other. However, the estimated values and the actual measured values exhibit the same decreasing tendency over time. Therefore, it can be said that the results of estimation of the battery capacity by the battery capacity estimation device according to the present embodiment are relatively accurate.

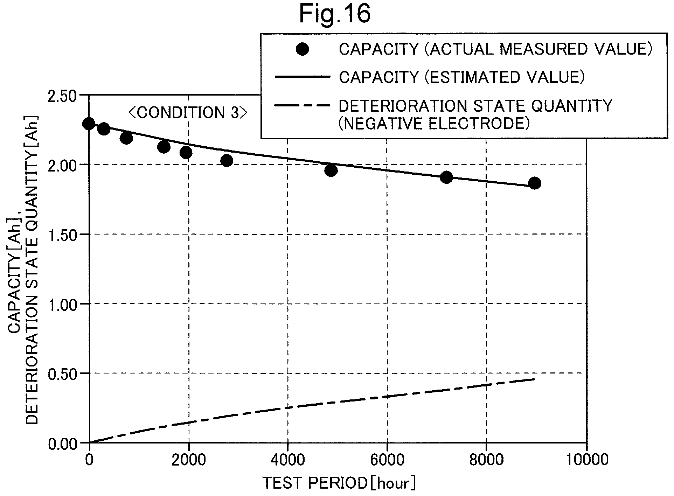

FIG. 16 is a graph showing battery capacities estimated when charging and discharging is performed under the condition 3, and a transition of actual measured values of battery capacities when charging and discharging is performed under the condition 3. FIG. 16 also shows a transition of estimated values of capacity losses (deterioration state quantities) in the negative electrode active material due to a crack in the SEI film. Note that, in Expressions 10 and 11 described above, coef = 0.17 and m = 2. As can be seen from FIG. 16, the results of estimation and the actual measured values of the battery capacity substantially match. Therefore, it can be said that the results of estimation of the battery capacity by the battery capacity estimation device according to the present embodiment are relatively accurate.

As described above, it can be said that the battery capacity estimation device according to the present embodiment can relatively accurately estimate the battery capacity after deterioration taking the influence of a crack into account, regardless of how charging and discharging is performed.

### Fourth Embodiment

A battery capacity estimation device according to a fourth embodiment is different from the above embodiments with regard to the method for deriving the deterioration state quantity by deterioration state quantity derivation unit 4. The battery capacity estimation device according to the fourth embodiment will be described below. Note that the description of configurations that are the same as those in the above-described embodiments will be omitted.

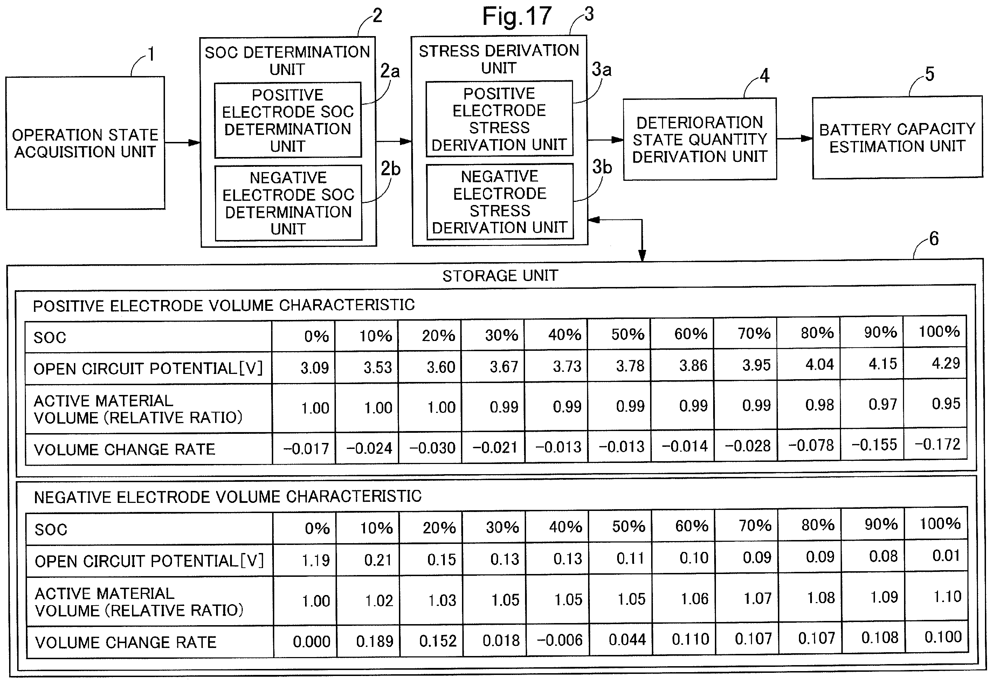

FIG. 17 is a diagram showing a configuration of the battery capacity estimation device according to the fourth embodiment. As illustrated, the battery capacity estimation device includes an operation state acquisition unit 1, an SOC determination unit 2, a stress derivation unit 3, the deterioration state quantity derivation unit 4, and the battery capacity estimation unit 5. Specifically, the battery capacity estimation device according to the fourth embodiment derives both a deterioration state quantity of the positive electrode active material due to a crack generated in the positive electrode active material as a result of volume change of the positive electrode active material occurring with charging and discharging of the secondary battery, and a deterioration state quantity of an SEI film formed on the surface of the negative electrode active material due to a crack generated in the SEI film as a result of volume change of the negative electrode active material occurring with charging and discharging of the secondary battery, and estimates the battery capacity of the secondary battery after deterioration, based on the deterioration states. Therefore, the SOC determination unit 2 includes a positive electrode SOC determination unit 2a and a negative electrode SOC determination unit 2b, and the stress derivation unit 3 includes a positive electrode stress derivation unit 3a and a negative electrode stress derivation unit 3b.

### Deterioration State Quantity of Positive Electrode

In the present embodiment, the positive electrode SOC determination unit 2a determines the positive electrode SOC at time t based on Expression 14 below. Note that Δqₜ is derived based on Expression 20, which will be described later.
[Math. 13] ${SOC}_{t}^{cathode} = \left({SOC}_{t}^{cell}\times {Q}_{t - 1}+Δ{q}_{t - 1}\right) / \left({Q}_{t - 1}+Δ{q}_{t - 1}\right)$
${SOC}_{c}^{cathode}$ : positive electrode SOC at time t
${SOC}_{t}^{ceu}$ : battery SOC at time t
*Q*_{*t-*1} : battery capacity at time t-1
Δ*q*_{*t*-1}: amount of deviation between capacity regions of positive and negative electrodes at time t-1 (amount of deterioration due to crack in SEI film is added to amount of lithium consumed by formation of SEI film during manufacture)

The positive electrode stress derivation unit 3a derives, based on a product of a volume change rate of the positive electrode active material that corresponds to an SOC of the positive electrode active material at a predetermined timing, the SOC being determined by the positive electrode SOC determination unit 2a, and the volume change rate being determined by referring to positive electrode volume characteristics indicating relations between SOCs of the positive electrode active material and volumes of the positive electrode active material, a charge-discharge current at the predetermined timing, and a ratio of the initial battery capacity of the secondary battery relative to the battery capacity of the secondary battery at the past timing, a stress applied to particles of the positive electrode active material (e.g., stress on the particle surface) at the predetermined timing. In the present embodiment, the stress is derived based on Expression 15 below. As stored in the storage unit 6, the positive electrode volume characteristics define relations between positive electrode SOCs, open circuit potentials, active material volumes (relative ratios), and volume change rates. Note that, for simplicity of illustration, FIG. 17 describes the SOC in increments of 10%.
[Math. 14] ${σ}_{θ , max} = coef \times V {′}_{\left(soc\right)} \times i \times {Q}_{0} / {Q}_{t ⋅ l}$
*σ*_{*θ*,*max*} : maximum stress (= stress on particle surface) applied in tangential direction of active material particles
*coef* : proportional constant dependent on battery design
*V'* _{*isoc*)}: volume change rate of electrode active material relative to positive electrode SOC
*I* : charge-discharge current
*Q₀:*
*Qₜ₋₁* : battery capacity at time t

As in the first embodiment described above, the deterioration state quantity derivation unit 4 derives the deterioration state quantity of the positive electrode active material due to a crack generated in the positive electrode active material, the deterioration state quantity being derived based on a temporal change state (e.g., a fluctuation range of the stress on the particle surface and the number of cycles of stress fluctuation) of stresses applied to the particles of the positive electrode active material, the stresses being derived by the positive electrode stress derivation unit 3a at a plurality of timings. For example, the deterioration state quantity derivation unit 4 derives a crack density in the positive electrode active material particles based on Expressions 3 and 4 described in the first embodiment, and derives a capacity loss (deterioration state quantity) of the positive electrode active material based on Expression 5 described in the first embodiment.
[Math. 15] ${μ}_{t}^{crack} = {Q}_{0} \left(1-{\left(1-{\overline{a}}_{t}\right)}^{β}\right)$
${μ}_{t}^{crack}$ : capacity loss (deterioration state quantity) in positive electrode active material isolated from conductive paths due to crack
*β* : index that defines probability that active material is isolated due to crack

### Deterioration State Quantity of Negative Electrode

The negative electrode SOC determination unit 2b determines the SOC of the negative electrode active material at the predetermined timing from a relation between the battery SOC and the negative electrode SOC, and the SOC of the secondary battery at the predetermined timing. In the present embodiment, as the relation between the battery SOC and the negative electrode SOC, a relation as described in Expression 16 below is defined. That is, the negative electrode SOC determination unit 2b determines the SOC of the negative electrode active material at the predetermined timing, based on the SOC of the secondary battery at the predetermined timing, a battery capacity of the secondary battery at a past timing before the predetermined timing, and the capacity of the negative electrode active material.
[Math. 16] ${SOC}_{c}^{anode} = \left({SOC}_{t}^{cell}\times {Q}_{t - 1}\right) / {Q}_{anode}$
${SOC}_{t}^{anode}$ : negative electrode SOC at time t
${SOC}_{t}^{cell}$ : battery SOC at time t
*Q*_{*t*-1} : battery capacity at time t-1
*Q_{anode}* : negative electrode capacity

With Expression 16 above, a change in the usable range of the negative electrode due to deterioration can be accurately calculated by calculating the negative electrode SOC using the current battery capacity of the secondary battery and the negative electrode capacity.

The negative electrode stress derivation unit 3b included in the stress derivation unit 3 derives, based on a volume of the negative electrode active material that corresponds to an SOC of the negative electrode active material at a predetermined timing, the SOC being determined by the negative electrode SOC determination unit 2b, and the volume being determined by referring to negative electrode volume characteristics indicating relations between SOCs of the negative electrode active material and volumes of the negative electrode active material, a stress applied in a plane direction of the SEI film at the predetermined timing. In the present embodiment, the stress is derived based on Expression 17 below. As stored in the storage unit 6, the negative electrode volume characteristics define relations between negative electrode SOCs, open circuit potentials, active material volumes (relative ratios), and volume change rates. Note that, for simplicity of illustration, FIG. 17 describes the SOC in increments of 10%.
[Math. 17] ${σ}_{θ , max} = coef \times V {′}_{\left(soc\right)}$
- *σ*_{*θ*,*max*} ;: stress applied in plane direction of SEI film
- *coef* :: proportional constant dependent on battery design
- *V'* _{(*soc*)} :: active material volume (relative value with respect to SOC 0%)

The deterioration state quantity derivation unit 4 derives the deterioration state quantity of the SEI film due to a crack generated in the SEI film, the deterioration state quantity being derived based on a temporal change state (a fluctuation range of stresses and the number of cycles of stress fluctuation) of stresses applied in the plane direction of the SEI film, and the stresses being derived by the negative electrode stress derivation unit 3b at a plurality of timings.

First, the deterioration state quantity derivation unit 4 derives an increment of a crack density in the SEI film of the negative electrode, based on a fluctuation range of stress generated over time, and the number of cycles of stress fluctuation counted using the Rainflow counting method. In the present embodiment, the increment of the crack density is derived based on Expression 18 below.
[Math. 18] $Δ {μ}_{t} = {\sum }_{i} \left({N}_{i}\times Δ{{σ}_{i}}^{m}\right)$
- Δ*µₜ*:: increment of deterioration state quantity due to crack in SEI film due to stress fluctuation cycles, counted from time t-1 to t
- *N*₁:: number of cycles of ith stress fluctuation counted from time t-1 to t (1 or 1.5)
- Δσ*ₜ* :: fluctuation range of ith stress σ counted from time t-1 to t
- *m* :: exponent

Next, the deterioration state quantity derivation unit 4 derives a deterioration state quantity of the SEI film due to a crack generated in the SEI film, the deterioration state quantity being derived based on a temporal change state (a fluctuation range of stress and the number of cycles of stress fluctuation) of stresses applied in plane direction of the SEI film, the stresses being derived by the negative electrode stress derivation unit 3b at a plurality of timings. In the present embodiment, the deterioration state quantity of the SEI film of the negative electrode active material is derived based on Expression 19 below.
[Math. 19] ${μ}_{t}^{SEI} = {μ}_{t - 1}^{SEI} + Δ {μ}_{t}$
${μ}_{t}^{SEI}$ : deterioration state quantity due to crack in SEI film at time t

The battery capacity estimation unit 5 estimates a battery capacity of the secondary battery after deterioration, based on the deterioration state quantities on the positive electrode side and the negative electrode side derived by the deterioration state quantity derivation unit 4. In the present embodiment, the battery capacity is estimated based on Expression 20 below.
$\begin{matrix}{Q}_{t} = {Q}_{0} - \left({μ}_{t}^{crack}+{μ}_{t}^{SEI}\right) \left(Expression 20\right) \\ Δ {q}_{t} = Δ {q}_{0} + {μ}_{t}^{SEI} \left(Expression 21\right)\end{matrix}$
- *Qₜ*:: battery capacity at time t
- *Q*₀:: initial (new) battery capacity of secondary battery
- Δ*qₜ*:: amount of deviation between capacity regions of positive and negative electrodes at time t
- Δ*q*₀:: amount of deviation between initial capacity regions of positive and negative electrodes

In Expression 21 above, the amount of deviation Δqₜ between the capacity regions of positive and negative electrodes at the predetermined timing, or in other words, the amount of capacity that no longer contribute to charging and discharging as a result of the capacity regions of the positive and negative electrodes deviating from each other due to side reactions such as growth of the SEI film, is determined by adding the amount of deviation due to a crack in the SEI to the initial amount of deviation.

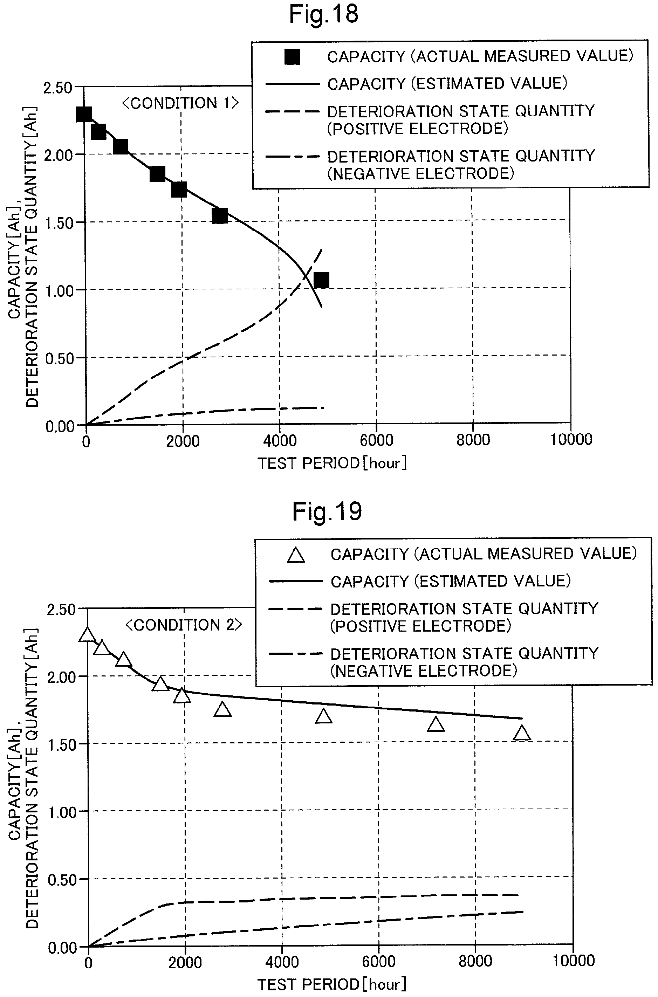

FIG. 18 is a graph showing battery capacities estimated when charging and discharging is performed under the condition 1, and a transition of actual measured values of battery capacities when charging and discharging is performed under the condition 1. FIG. 18 also shows a transition of estimated values of capacity losses (deterioration state quantities) in the positive electrode active material due to the crack. Note that, in Expressions 3, 5, and 15 described above, coef = 0.184, m = 3, and β = 0.6. In Expressions 17, 18, and 21 described above, coef = 0.126, m = 2, and Δq₀ = 0.14. As can be seen from FIG. 18, the longer the test period, the more deviated the estimated values are from the actual measured values. However, the estimated values and the actual measured values exhibit substantially the same transition up to a test period of about 2000 hours. Therefore, it can be said that the results of estimation of the battery capacity by the battery capacity estimation device according to the present embodiment are relatively accurate.

FIG. 19 is a graph showing battery capacities estimated when charging and discharging is performed under the condition 2, and a transition of actual measured values of battery capacities when charging and discharging is performed under the condition 2. FIG. 19 also shows a transition of estimated values of capacity losses (deterioration state quantities) in the positive electrode active material due to the crack. Note that, in Expressions 3, 5, and 15 described above, coef = 0.184, m = 3, and β = 0.6. In Expressions 17, 18, and 21 described above, coef = 0.126, m = 2, and Δq₀ = 0.14. As can be seen from FIG. 19, the longer the test period, the more deviated the estimated values are from the actual measured values. However, the estimated values and the actual measured values exhibit substantially the same transition up to a test period of about 2000 hours. The characteristic by which the transition of the battery capacity tends to level out after the test period exceeds 2000 hours is similar between both the estimated value and the actual measured value. Therefore, it can be said that the results of estimation of the battery capacity by the battery capacity estimation device according to the present embodiment are relatively accurate.

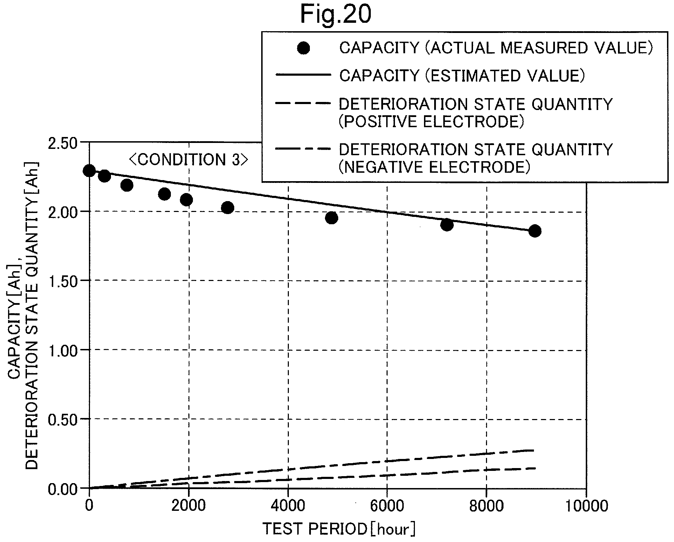

FIG. 20 is a graph showing battery capacities estimated when charging and discharging is performed under the condition 3, and a transition of actual measured values of battery capacities when charging and discharging is performed under the condition 3. FIG. 20 also shows a transition of estimated values of capacity losses (deterioration state quantities) in the positive electrode active material due to the crack. Note that, in Expressions 3, 5, and 15 described above, coef = 0.184, m = 3, and β = 0.6. In Expressions 17, 18, and 21 described above, coef = 0.126, m = 2, and Δq₀ = 0.14. As can be seen from FIG. 20, both the estimated value and the actual measured value of the battery capacity become smaller over time. Therefore, it can be said that the results of estimation of the battery capacity by the battery capacity estimation device according to the present embodiment are relatively accurate.

### Alternative Embodiments

In the above embodiments, the configuration of the battery capacity estimation device has been described using specific examples. However, the configuration can be changed as appropriate.

Specifically, in each of the above embodiments, the battery capacity estimation device is not limited to battery capacity estimation devices composed of the functional blocks shown in FIGS. 1, 13, and FIG. 17, and may be composed of any functional blocks. For example, each of the functional blocks of the battery capacity estimation device may be further subdivided. Conversely, part or all of each of the functional blocks may be consolidated.

In the above embodiments, the secondary battery targeted for estimation of the battery capacity is not particularly limited, and various types of secondary batteries can be targeted for estimation of the battery capacity.

In the above embodiments, the method for determining the positive electrode SOC and the negative electrode SOC are specifically illustrated. However, other methods may be used to determine the positive electrode SOC and the negative electrode SOC. For example, the determination method using Expression 16 described in the fourth embodiment may be adopted in the third embodiment.

The configurations disclosed in the above-described embodiments (including the alternative embodiments; the same applies to the following) are applicable in combination with configurations disclosed in other embodiments so long as no inconsistency arises. The embodiments disclosed herein are illustrative, and embodiments of the present invention are not limited thereto. Appropriate changes and modifications may be made without departing from the scope and sprit of the present invention.

### Industrial Applicability

The present invention is applicable to a battery capacity estimation device and a battery capacity estimation program that can estimate a battery capacity taking the influence of a crack into account.

### Description of Reference Signs

1: Operation state acquisition unit
2: SOC determination unit
2a: Positive electrode SOC determination unit
2b: Negative electrode SOC determination unit
3: Stress derivation unit
3a: Positive electrode stress derivation unit
3b: Negative electrode stress derivation unit
4: Deterioration state quantity derivation unit
5: Battery capacity estimation unit

## Claims

1. A battery capacity estimation device for estimating a battery capacity of a secondary battery that includes a positive electrode including a positive electrode active material, a negative electrode including a negative electrode active material, and an electrolyte, the battery capacity estimation device comprising:
a deterioration state quantity derivation unit configured to derive at least one of a deterioration state quantity of the positive electrode active material due to a crack generated in the positive electrode active material as a result of volume change of the positive electrode active material occurring with charging and discharging of the secondary battery, and a deterioration state quantity of a solid electrolyte interface (SEI) film due to a crack generated in the SEI film as a result of volume change of the negative electrode active material occurring with charging and discharging of the secondary battery, the SEI film being formed on a surface of the negative electrode active material; and
a battery capacity estimation unit configured to estimate a battery capacity of the secondary battery after deterioration, based on the deterioration state quantity derived by the deterioration state quantity derivation unit.

2. The battery capacity estimation device according to claim 1, further comprising:
a positive electrode SOC determination unit configured to determine a state of charge (SOC) of the positive electrode active material; and
a positive electrode stress derivation unit configured to derive, based on a product of a volume change rate of the positive electrode active material that corresponds to an SOC of the positive electrode active material at a predetermined timing, the SOC being determined by the positive electrode SOC determination unit, and the volume change rate being determined by referring to positive electrode volume characteristics indicating relations between SOCs of the positive electrode active material and volumes of the positive electrode active material, and a charge-discharge current at the predetermined timing, a stress applied to particles of the positive electrode active material at the predetermined timing,
wherein the deterioration state quantity derivation unit derives the deterioration state quantity of the positive electrode active material due to a crack generated in the positive electrode active material, the deterioration state quantity being derived based on a temporal change state of stresses applied to particles of the positive electrode active material, the stresses being derived by the positive electrode stress derivation unit at a plurality of timings.

3. The battery capacity estimation device according to claim 2,
wherein the positive electrode SOC determination unit determines an SOC of the positive electrode active material at the predetermined timing, based on the SOC of the secondary battery at the predetermined timing, a battery capacity of the secondary battery at a past timing before the predetermined timing, and an amount of deviation between a capacity region of the positive electrode active material and a capacity region of the negative electrode active material, and
the positive electrode stress derivation unit derives a stress applied to particles of the positive electrode active material at the predetermined timing, based on a product of the volume change rate of the positive electrode active material, the charge-discharge current at the predetermined timing, and a ratio of an initial battery capacity of the secondary battery to the battery capacity of the secondary battery at the past timing.

4. The battery capacity estimation device according to any one of claims 1 to 3, further comprising:
a negative electrode SOC determination unit configured to determine an SOC of the negative electrode active material; and
a negative electrode stress derivation unit configured to derive, based on a volume of the negative electrode active material that corresponds to an SOC of the negative electrode active material at a predetermined timing, the SOC being determined by the negative electrode SOC determination unit, and the volume being determined by referring to negative electrode volume characteristics indicating relations between SOCs of the negative electrode active material and volumes of the negative electrode active material, a stress applied in a plane direction of the SEI film at the predetermined timing,
wherein the deterioration state quantity derivation unit derives the deterioration state quantity of the SEI film due to a crack generated in the SEI film, the deterioration state quantity being derived based on a temporal change state of stresses applied in the plane direction of the SEI film, and the stresses being derived by the negative electrode stress derivation unit at a plurality of timings.

5. The battery capacity estimation device according to claim 4,
wherein the negative electrode SOC determination unit determines an SOC of the negative electrode active material, based on the SOC of the secondary battery at the predetermined timing, a battery capacity of the secondary battery at a past timing before the predetermined timing, and a capacity of the negative electrode active material.

6. A battery capacity estimation program for causing a computer to function as the units included in the battery capacity estimation device according to any one of claims 1 to 3.
